# DEMANDE DE BREVET EUROPEEN

(11) **EP 4 646 087 A1**
(43) Date de publication de la demande: **05.11.2025**
(21) Numéro de dépôt: 25172796.2
(22) Date de dépôt: 28.04.2025
(51) Int. Cl.: H10N 50/01, H10N 50/10, H10N 50/80

(54) **DISPOSITIF MAGNÉTIQUE À EFFET HALL ORBITAL ET PROCÉDÉ DE FABRICATION D'UN TEL DISPOSITIF**

(30) Priorité: 30.04.2024 FR 2404522
(71) Demandeur: Commissariat à l'Energie Atomique et aux Energies Alternatives, 75015 Paris (FR); Université Grenoble Alpes, 38400 Saint-Martin-d'Hères (FR); Centre National de la Recherche Scientifique, 75016 Paris (FR); Institut Polytechnique de Grenoble, 38000 Grenoble (FR)
(72) Inventeur: VIALA, Bernard, 38054 GRENOBLE CEDEX 09 (FR); GARELLO, Kévin, 38054 GRENOBLE CEDEX 09 (FR)
(74) Mandataire: Cabinet Camus Lebkiri

(57) **Abrégé**

L'invention vise à fournir un dispositif magnétique (1) à effet Hall orbital qui soit simple à exécuter et qui offre un contrôle d'une aimantation au moins équivalente aux dispositifs de l'art antérieur. Pour cela le dispositif comprend :
- une jonction tunnel magnétique ;
- un espaceur conducteur comprenant un faible couplage spin-orbit et une longueur moyenne de diffusion de moments orbitaux élevée ; et
- une piste conductrice apte à générer un courant de moments orbitaux à partir d'un courant de charges et présentant un couplage spin-orbite faible.

## Description

### DOMAINE TECHNIQUE DE L'INVENTION

Le domaine technique de l'invention est celui des dispositifs magnétiques tels qu'une mémoire ou un capteur de champ magnétique, et plus particulièrement les dispositifs magnétique exploitant l'effet Hall orbital (dit « OHE »).

### ARRIÈRE-PLAN TECHNOLOGIQUE DE L'INVENTION

Les mémoires magnétiques non-volatiles utilisent par exemple une jonction tunnel magnétique (dite « JTM » ou « jonction tunnel » ou encore « MTJ » pour « Magnetic Tunnel Junction » en anglais) constituée de deux couches magnétiques séparées par une couche isolante non magnétique. L'une des couches magnétiques est dite « couche piégée » ou « couche de référence » car elle présente une aimantation fixe. L'autre couche magnétique est dite « couche libre » ou « couche de stockage » car elle présente une aimantation variable pouvant prendre des valeurs ou des orientations distinctes. La couche isolante non magnétique est dire « barrière tunnel » car elle joue le rôle de barrière tunnel lors du transport électronique entre les deux couches magnétiques. L'orientation relative de l'aimantation de la couche libre par rapport à l'aimantation de la couche de référence permet de stocker une information. La différence de résistance de la jonction tunnel permet de lire l'information stockée (c'est-à-dire l'orientation d'une aimantation par rapport à l'autre). Par exemple, une configuration parallèle des aimantations correspond à un état de résistance électrique minimale et par exemple à un état bas, c'est-à-dire un bit de donnée « 0 ». La configuration antiparallèle des aimantations correspond à un état de résistance maximale et par exemple à un état haut, c'est-à-dire un bit de donnée « 1 ». La différence relative s'exprime en pourcentage de magnétorésistance tunnel (dite « TMR » pour « Tunnel MagnetoResistance » en anglais) qui est habituellement de l'ordre de 100 % à 150 % pour des jonctions usuelles dites « top pinned » et de l'ordre de 150 % à 200 % pour des jonctions usuelles dites « bottom pinned ». Les couches piégée et libre possèdent le plus souvent des orientations d'aimantation qui sont perpendiculaires par rapport au plan des couches. On parle alors de jonction magnétique tunnel perpendiculaire ou « pMTJ » pour « perpendicular magnetic tunnel junction » en anglais.

Les jonctions tunnels magnétiques sont également connus pour être utilisées en tant que capteur de champ magnétique.

Une première génération de dispositifs magnétiques (pouvant être utilisées comme mémoires magnétiques ou capteurs) repose sur un effet de transfert de couple de spin (dit également « transfert de spin » ou encore « STT » pour « Spin Transfer Torque » en anglais) pour exercer un couple sur l'aimantation de la couche libre. Le transfert de spin repose sur la circulation d'un courant électrique traversant la jonction tunnel. La jonction tunnel magnétique est donc usuellement reliée à deux terminaux.

Une seconde génération de dispositifs magnétiques repose sur un effet de couple spin-orbite également appelé « effet de couple spin-orbital » ou encore « spin-orbite », voire « SOT » pour « Spin-Orbit Torque » en anglais. Un dispositif spin-orbite comprend, en plus de la jonction tunnel magnétique, une piste d'écriture dite également piste spin-orbite, le plus souvent réalisée dans un métal de transition lourd tel que Pt ou β-W. L'effet spin-orbite est un phénomène qui permet de transmettre un couple au niveau d'une interface. La piste spin-orbite est donc disposée directement en contact avec la couche libre de la jonction tunnel magnétique. La circulation d'un courant électrique dans la piste spin-orbite, et pas à travers la jonction tunnel, permet de générer un courant de spin (différent d'un courant électronique) pouvant être appelé courant Hall de spins (ou « SHE » pour « Spin Hall Effect » en anglais) qui peut exercer un couple sur l'aimantation de la couche libre. L'effet spin-orbite offre l'avantage de séparer les chemins de circulation du courant réalisant la lecture (et circulant à travers la jonction tunnel) du courant d'écriture (circulant uniquement dans la piste spin-orbite). À la différence des dispositifs reposant sur le transfert de spin, les dispositifs reposant sur le couple spin-orbite nécessitent trois terminaux. Deux d'entre eux relient la piste spin-orbite, pour exercer un couple sur l'aimantation de la couche libre (que l'on appellera écriture), et un troisième relie la jonction tunnel, à l'opposé de la piste spin-orbite, pour réaliser la lecture de l'état de la jonction tunnel magnétique.

Bien que moins compacte que les dispositifs à transfert de spin, les dispositifs spin-orbite offrent une plus grande endurance car le courant électrique d'écriture parcourt uniquement la piste spin-orbite et ne traverse pas la barrière tunnel (celle-ci n'est plus que traversée par le courant de lecture qui est toujours plus faible que le courant d'écriture). Ils peuvent également être plus rapides car leur temps d'écriture par effet spin-orbite peut être plus court (par exemple compris entre 0,3 ns et 1 ms) que le temps d'écriture par effet de transfert de spin (qui est généralement compris entre 10 ns et 100 ns). Enfin, les dispositifs spin-orbite sont dotées d'une meilleure performance énergétique (en consommation électrique par jonction). Ces avantages orientent donc l'utilisation des dispositifs spin-orbite, et des mémoires vives qui peuvent en découler (dites « SOT-MRAM » pour « SOT Magnetic Random Access Memory » en anglais), vers des applications embarquées ou de type « cache » (mémoire à laquelle un microprocesseur accède plus rapidement et plus fréquemment lors de calculs). Par exemple, les SOT-MRAM ont pour vocation de remplacer les mémoires vives statiques telles que les « Embedded SRAM » qui n'ont pas d'alternative à ce jour. Cependant, les procédés de fabrications des dispositifs spin-orbite et des SOT-MRAM sont plus complexes et ne sont pas encore totalement maitrisés.

Une alternative aux dispositifs magnétiques reposant sur la conversion d'un courant de charges (par exemple d'électrons) en courant de spin consiste à exploiter une autre forme d'écriture en courant tout en gardant l'avantage d'un chemin d'écriture séparé du chemin de lecture. L'écriture se fait par conversion du courant de charges en un courant de moments orbitaux qui a une aptitude similaire au courant de spins à exercer un couple sur l'aimantation d'une couche magnétique. Il s'agit de l'effet Hall orbital (dit « OHE » pour « Orbital Hall Effect » en anglais) qui diffère de l'effet Hall de spins. L'écriture par effet Hall orbital est une bonne candidate pour améliorer les caractéristiques des dispositifs magnétiques.

La structure d'un dispositif à effet Hall orbital est similaire à celle d'un dispositif spin-orbite à la différence que la piste d'écriture, dite également piste « OT » pour « Orbital Torque » en anglais, est une piste configurée pour générer un courant de moments orbitaux à partir d'un courant de charges.

Le document US 2023/0309411 A1 divulgue par exemple un dispositif magnétique comprenant une jonction tunnel magnétique, une piste conductrice s'étendant dans un plan et apte à générer un courant de moments orbitaux et une fine couche de conversion intercalée entre la jonction tunnel et la piste conductrice. La fine couche de conversion permet de convertir le courant de moments orbitaux issu de la piste conductrice en un courant de spins pour que ces derniers puissent exercer un couple de spin-orbite sur la couche libre de la jonction tunnel magnétique.

Un dispositif à effet Hall orbital tel que celle présenté dans le document précité peut être réalisée au moyen de procédés utilisés pour réaliser les dispositifs spin-orbite. Toutefois, comme pour les dispositifs spin-orbite et les SOT-MRAM, les procédés de fabrications des dispositifs à effet Hall orbital sont complexes et ne sont pas encore totalement maitrisés.

Il existe donc un besoin de fournir un dispositif magnétique qui soit plus simple à réaliser et qui permette un contrôle de l'aimantation par effet Hall orbital avec une efficacité de contrôle au moins équivalente aux dispositifs de l'art antérieure.

### RÉSUMÉ DE L'INVENTION

Pour cela, l'invention concerne un dispositif magnétique comprenant :
- une jonction tunnel magnétique ;
- un espaceur conducteur ; et
- une piste conductrice,

l'espaceur conducteur s'étendant dans le prolongement de la jonction tunnel magnétique selon une direction perpendiculaire à un plan, le plan étant dit « plan des couches », l'espaceur conducteur étant disposé entre la jonction tunnel magnétique et la piste conductrice, l'espaceur conducteur étant en contact direct avec la piste conductrice, la piste conductrice comprenant au moins une portion s'étendant parallèlement au plan des couches et directement contre l'espaceur conducteur, l'espaceur conducteur présentant :
   - un couplage spin-orbite moyen strictement inférieur à 136 eV ;
   - une longueur moyenne de diffusion de moments orbitaux strictement supérieure à 10 nm ;
   - une épaisseur inférieure à la longueur moyenne de diffusion de moments orbitaux,
la piste conductrice étant apte à générer un courant de moments orbitaux à partir d'un courant de charges et présentant un couplage spin-orbite strictement inférieur à 136 eV.

Par « jonction tunnel magnétique », on entend un empilement de couches comprenant deux couches magnétiques séparées par une couche isolante apte à laisser circuler un courant d'électrons par effet tunnel.

Par « espaceur » on entend une couche destinée à espacer la jonction tunnel magnétique et la piste conductrice.

Par « conducteur » ou « conductrice », on entend présentant une conductivité électrique (préférentiellement moyennée sur le volume de l'élément considéré) supérieure à 10³ S/m et préférentiellement à 10⁴ S/m.

Par « l'espaceur conducteur s'étend dans le prolongement de la jonction tunnel magnétique », on entend que la jonction tunnel magnétique et l'espaceur sont délimités par un même flanc. Par « flanc », on entend une surface s'étendant perpendiculairement au plan des couches.

Par « contact direct », on entend un contact sans intermédiaire.

Par « épaisseur », on entend une dimension mesurée perpendiculairement au plan des couches.

Par « piste », on entend une couche présentant une longueur et une largeur, mesurées parallèlement au plan des couches, sa longueur étant plus grande que sa largeur.

Par « couplage spin-orbite moyen d'un élément », on entend une moyenne sur le volume de l'élément du couplage spin-orbite réalisée sur tout le volume de l'espaceur.

Par « longueur moyenne de diffusion de moments orbitaux d'un élément », on entend une moyenne sur le volume de l'élément de la longueur moyenne de diffusion de moments orbitaux.

Par « parallèlement » et « parallèle », on entend parallèle à 20° près, voire 10° et de manière préférée à 5° près. De manière similaire, par « perpendiculairement » et « perpendiculaire », on entend perpendiculaire à 20° près, voire 10° et de manière préférée à 5° près.

Par « courant de charges », on entend un courant de porteurs de charge pouvant être un courant d'électrons et/ou de trous.

Par « longueur de diffusion de moment orbital », on entend une distance caractéristique de déplacement du moment orbital en considérant un déplacement par diffusion. Un exemple de longueur de diffusion de moment orbital est donné pour le titane dans le document [Choi & al. "Observation of the orbital Hall effect in a light metal Ti", Nature 2023, vol. 619, no 7968, p. 52-56.]

Le dispositif magnétique offre un moyen de contrôler une aimantation de la jonction tunnel magnétique par effet Hall orbital. La circulation d'un courant longitudinal de charges (c'est-à-dire parallèle au plan des couches) dans la piste conductrice, permet de créer un courant transversal de moments orbitaux (c'est-à-dire perpendiculaire au plan des couche) dans la piste conductrice. Le courant de moments orbitaux est alors injecté dans l'espaceur conducteur qui est au contact de la piste conductrice. L'espaceur permet de propager le courant de moments orbitaux vers l'empilement magnétique pour appliquer un couple sur une aimantation de la jonction tunnel magnétique. Puisque la longueur moyenne de diffusion des moments orbitaux est plus grande que l'épaisseur de l'espaceur, une partie significative du courant de moments orbitaux traverse l'espaceur et peut être injecté au niveau de la jonction tunnel. Ce courant de moments orbitaux peut donc exercer un couple de spin-orbite sur une aimantation de la jonction tunnel. Ce courant de moments orbitaux permet de contrôler une aimantation de la jonction tunnel pour entraîner une précession de cette dernière et/ou réaliser sa commutation. L'espaceur permet donc de délocaliser l'effet de Hall orbital (dit « OHE ») de la piste conductrice.

La distanciation offerte par l'espaceur permet également de relâcher la contrainte sur la fabrication de la piste conductrice. Il est par exemple possible de recourir à des matériaux dont les procédés de fabrication ne sont pas compatibles avec ceux d'une jonction tunnel à proximité immédiate.

Le couplage spin-orbite favorise la conversion d'un courant de charges électriques en courant de spins. Sans couplage spin-orbite, un courant de charges électriques peut être théoriquement converti en courant de moments orbitaux.

Un couplage spin-orbite faible permet de générer un courant de spins faible, voire négligeable et un courant de moments orbitaux fort, voire dominant. Un courant de spins et un courant de moments orbitaux peuvent interagir de manière constructive et/ou destructive l'un avec l'autre d'une manière qui peut être difficile à contrôler. Cette interaction constructive/destructive peut dépendre des matériaux considérés pour la piste conductrice et/ou l'espaceur. Elle peut également dépendre de l'épaisseur de l'espaceur. En effet la compétition entre les courants de spins et de moments orbitaux peut entraîner une réduction rapide du courant total en fonction de la distance. Réduire, voire annuler ces interactions constructives/destructives permet de mieux contrôler l'amplitude du courant de moments orbitaux au niveau de la jonction tunnel et donc de mieux contrôler le couple exercé sur l'aimantation libre de cette jonction.

Par rapport à un dispositif dont la piste (dite piste « SOT » pour « Spin Orbit Torque » en anglais) est apte à générer un courant de spins à partir d'un courant de charges, le dispositif de l'invention présente plusieurs avantages. Pour générer un courant de spin, les matériaux usuellement considérés présente un couplage spin-orbite pouvant être supérieur à 680 eV, soit 50 Ry (en considérant 1 Ry = 13,6 eV). Toutefois ces matériaux présentent généralement une conductivité faible, de l'ordre de 10² S/m. Cette faible conductivité réduit l'efficacité énergétique des dispositifs résultants mais implique également de former des pistes très fines, avec une épaisseur inférieure à 10 nm et avoisinant 4 nm. Ces faibles épaisseurs contraignent fortement la fabrication de telles pistes car sans contrôle précis de la profondeur de gravure des dispositifs, ces pistes sont généralement coupées.

Les matériaux pour former une piste apte à générer un courant de moments orbitaux sont généralement plus simples à utiliser. Ils présentent par exemple une conductivité électrique important, permettant de former des pistes conductrices épaisses, de l'ordre de 100 nm, et donc robustes à la gravure (même si la profondeur de gravure n'est pas bien contrôlée).

Avantageusement, l'espaceur conducteur présente une épaisseur supérieure ou égale à 20 nm.

Avantageusement, le couplage spin-orbite moyen de l'espaceur conducteur est strictement inférieur à 13,6 eV.

Avantageusement, la piste conductrice présente une épaisseur strictement supérieure à 10 nm et préférentiellement supérieure à 50 nm.

Avantageusement, le couplage spin-orbite moyen de la piste conductrice est strictement inférieur à 13,6 eV.

Avantageusement, la piste conductrice est apte à convertir au moins 10 % du courant de charge en courant de moments orbitaux et préférentiellement au moins 50 % du courant de charge en courant de moments orbitaux.

Avantageusement, le dispositif comprend un substrat. La jonction tunnel magnétique est disposée entre l'espaceur conducteur et le substrat ou l'espaceur conducteur est disposé entre la jonction tunnel magnétique et le substrat.

Avantageusement, l'espaceur conducteur est au contact direct de la jonction tunnel magnétique.

Avantageusement, le dispositif comprend une couche additionnelle, dite « couche de conversion », présentant un couplage spin-orbite supérieur à 680 eV, disposée entre la jonction tunnel magnétique et l'espaceur conducteur, la couche de conversion s'étendant directement contre la jonction tunnel magnétique et directement contre l'espaceur conducteur.

Avantageusement, la couche de conversion présente une épaisseur strictement inférieure à 10 nm.

L'invention concerne en outre un procédé de fabrication d'un dispositif magnétique comprenant les étapes suivantes :
- déposer un empilement magnétique s'étendant parallèlement à un plan, dit « plan des couches » et destiné à former, après gravure, une jonction tunnel magnétique ;
- déposer une couche conductrice sur l'empilement magnétique ;
- graver la couche conductrice de manière anisotrope pour former un espaceur conducteur ;
- graver l'empilement magnétique pour former une jonction tunnel magnétique, la gravure étant réalisée en employant l'espaceur conducteur comme masque de gravure, l'espaceur conducteur présentant, après la gravure de l'empilement magnétique :
   - un couplage spin-orbite moyen strictement inférieur à 136 eV ;
   - une longueur moyenne de diffusion de moments orbitaux strictement supérieure à 10 nm ; et
   - une épaisseur inférieure à la longueur moyenne de diffusion de moments orbitaux ; et
- former une piste conductrice au contact direct de l'espaceur conducteur à partir d'un matériau apte à générer un courant de moments orbitaux à partir d'un courant de charges et présentant un couplage spin-orbite strictement à 136 eV, la piste conductrice comprenant au moins une portion s'étendant parallèlement au plan des couches et directement contre l'espaceur conducteur.

Ce procédé permet de fabriquer un dispositif magnétique pour lequel l'espaceur repose sur la jonction tunnel. Cette configuration est dite « bottom pinned » car elle permet avantageusement de disposée l'une des couches magnétiques de la jonction, présentant une aimantation fixe, en bas du dispositif.

Les courants de moments orbitaux peuvent être dégradés par les interfaces qu'ils traversent, notamment lorsque la qualité de ces dernières n'est pas optimale. L'espaceur, après avoir été déposé sur l'empilement magnétique, protège l'état de surface dudit empilement. Dès lors, l'état de surface de l'empilement magnétique (sous l'espaceur) n'est pas impacté par les étapes de fabrication ultérieure (telle que la délimitation de l'empilement magnétique). Cet état de surface peut donc conserver une qualité optimale. Ainsi l'injection de moments orbitaux dans l'empilement magnétique est donc optimale. Par exemple l'empilement présente un état de surface obtenu lors de son dépôt et la couche conductrice est déposée sur l'empilement magnétique de manière à conserver l'état de surface dudit empilement. L'empilement magnétique et la couche conductrice sont par exemple déposés consécutivement sous vide, sans remise à l'air entre les deux dépôts. De cette manière, l'état de surface de la première couche magnétique est optimal.

La piste conductrice peut également être réalisée dans un second temps, sans qu'aucune dégradation de l'interface entre la jonction tunnel et l'espaceur ne soit à craindre

De plus, la protection offerte par l'espaceur permet également de protéger l'état de surface de l'empilement pour réaliser un nettoyage d'une surface de l'espaceur sur lequel sera reportée la piste conductrice. Ainsi, l'interface entre la piste conductrice et l'espaceur peut également être de bonne qualité, sans pour autant dégrader les autres interfaces.

L'épaisseur de l'espaceur n'est contrainte que par sa longueur moyenne de diffusion de moments orbitaux, qui impose une épaisseur finale maximale. Dès lors, la couche conductrice peut présenter une épaisseur initiale conséquente, par exemple aussi grande que nécessaire, pour subir des étapes de fabrication agressives, telles qu'un polissage ou une gravure, pour obtenir une piste conductrice ayant une forme adéquate.

À l'issue de ce procédé, l'empilement et l'espaceur sont délimités par un seul et même flanc.

Avantageusement, la couche conductrice présente une épaisseur initiale fonction de :
- l'épaisseur de l'empilement magnétique ;
- la vitesse de gravure de l'empilement magnétique ;
- la vitesse de gravure de la couche conductrice ; et
- la longueur moyenne de diffusion de moments orbitaux de l'espaceur conducteur après gravure de l'empilement magnétique,
- la vitesse de gravure de l'empilement magnétique et la vitesse de gravure de la couche conductrice étant considérées pour des conditions de gravure identiques.

Avantageusement, l'espaceur conducteur présente une vitesse de gravure inférieure à la vitesse de gravure de l'empilement magnétique, les vitesses de gravure de l'espaceur conducteur et de l'empilement magnétique étant considérées pour des conditions de gravure identiques.

Avantageusement, la couche conductrice est une multicouche comprenant une première sous-couche et une deuxième sous-couche, la deuxième sous-couche étant disposée entre la première sous-couche et l'empilement magnétique, la première sous-couche présentant une vitesse de gravure inférieure à la vitesse de gravure de l'empilement magnétique et inférieure à la vitesse de gravure de la deuxième sous-couche, les vitesses de gravure des première et deuxième sous-couches et de l'empilement magnétique étant considérées pour des conditions de gravure identiques.

Avantageusement, la formation de la piste conductrice comprend les sous-étapes de :
- déposer une couche diélectrique recouvrant l'espaceur conducteur ;
- graver une partie de la couche diélectrique avec arrêt sur le sommet de l'espaceur conducteur de sorte que la couche diélectrique présente un flanc s'étendant perpendiculairement au plan des couches et disposé dans le prolongement d'une partie d'un flanc de l'espaceur conducteur ;
- déposer la piste conductrice en partie contre la couche diélectrique et en partie contre l'espaceur conducteur, la piste conductrice présentant deux portions consécutives, l'une des portions, dite « portion parallèle », s'étendant parallèlement au plan des couches et directement contre l'espaceur conducteur, et l'autre des portions, dite « portion perpendiculaire », s'étendant perpendiculairement au plan des couches et directement contre le flanc de la couche diélectrique.

Avantageusement, la formation de la piste conductrice comprend les sous-étapes de :
- déposer une couche isolante contre un flanc de l'espaceur conducteur ;
- former une couche diélectrique s'étendant contre la couche isolante tout en laissant une portion de l'espaceur conducteur dégagée ;
- former un premier terminal conducteur et un deuxième terminal conducteur sur la couche diélectrique, de part et d'autre de l'espaceur, les premier et deuxième terminaux étant distants l'un de l'autre et séparés de l'espaceur par la couche isolante ;
- déposer la piste conductrice de sorte qu'elle s'étende parallèlement au plan des couches et contre la portion dégagée de l'espaceur, en reliant électriquement les premier et deuxième terminaux.

L'invention concerne également un procédé de fabrication d'un dispositif magnétique comprenant les étapes suivantes :
- déposer une couche conductrice s'étendant parallèlement à un plan, dit « plan des couches », la couche conductrice présentant un couplage spin-orbite moyen strictement inférieur à 136 eV, une longueur moyenne de diffusion de moments orbitaux strictement supérieure à 10 nm et apte à générer un courant de moments orbitaux à partir d'un courant de charges ;
- déposer un empilement magnétique sur couche conductrice, l'empilement magnétique étant destiné à former, après gravure, une jonction tunnel magnétique ;
- graver l'empilement magnétique pour former une jonction tunnel magnétique, la gravure étant réalisée à travers un masque de gravure,
- graver partiellement la couche conductrice à travers le masque de gravure pour former un espaceur conducteur et conserver une partie de la couche conductrice formant une piste conductrice en contact direct avec l'espaceur conducteur, l'épaisseur de l'espaceur conducteur étant inférieure à la longueur moyenne de diffusion de moments orbitaux, la piste conductrice comprenant au moins une portion s'étendant parallèlement au plan des couches et directement contre l'espaceur conducteur.

Ce procédé permet de fabriquer un dispositif magnétique pour lequel la jonction tunnel magnétique repose sur l'espaceur. Cette configuration est dite « top pinned » car elle permet avantageusement de disposée l'une des couches magnétiques de la jonction, présentant une aimantation fixe, en haut du dispositif.

L'empilement magnétique, après avoir été déposé sur l'espaceur, protège l'état de surface entre ledit empilement et ledit espaceur. Dès lors, l'état de surface entre l'empilement magnétique et l'espaceur n'est pas impacté par les étapes de fabrication ultérieure (telle que la délimitation de l'empilement magnétique). Cet état de surface peut donc conserver une qualité optimale. Ainsi l'injection de moments orbitaux dans l'empilement magnétique est donc optimale. Par exemple la couche conductrice et l'empilement magnétique peuvent être déposés de manière à conserver l'état de surface entre l'espaceur et l'empilement. Ils sont par exemple déposés consécutivement sous vide, sans remise à l'air entre les deux dépôts.

La piste conductrice est formée à partir de la même couche conductrice que l'espaceur. Ceci garantit une interface sans défaut entre les deux éléments.

Suivant ce procédé, ledit empilement et l'espaceur sont également délimités par un seul et même flanc.

L'invention et ses différentes applications seront mieux comprises à la lecture de la description qui suit et à l'examen des figures qui l'accompagnent.

### BRÈVE DESCRIPTION DES FIGURES

Les figures sont présentées à titre indicatif et nullement limitatif de l'invention. Sauf précision contraire, un même élément apparaissant sur des figures différentes présente une référence unique.
Les [Fig. 1], [Fig. 2], [Fig. 3] et [Fig. 4] présentent quatre modes de réalisation d'un dispositif magnétique à effet Hall orbital selon l'invention.
Les [Fig. 5], [Fig. 6], [Fig. 7], [Fig. 8], [Fig. 9] et [Fig. 10] présentent schématiquement différentes étapes d'un procédé de fabrication permettant d'obtenir un dispositif magnétique dans une configuration dite « bottom pinned ».
La [Fig. 11] présente schématiquement une étape d'un procédé de fabrication permettant d'obtenir un dispositif magnétique dans une configuration dite « top pinned ».

### DESCRIPTION DÉTAILLÉE

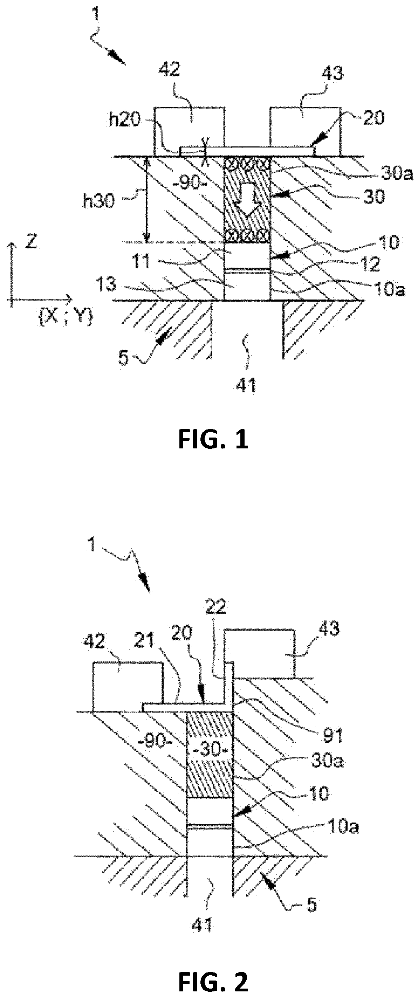

La figure 1 présente schématiquement un premier mode de réalisation d'un dispositif magnétique 1 selon l'invention. En particulier, dans cet exemple il s'agit d'une mémoire magnétique non-volatile utilisant un courant de moments orbitaux pour réaliser la commutation d'une aimantation de la mémoire. Dans la suite de la description, on utilisera indifféremment « dispositif », « dispositif magnétique », « mémoire » ou « capteur » pour décrire ce dispositif. Les enseignements concernant ce dispositif et présentés dans le cadre d'une mémoire de stockage non volatile peuvent être transposés à un capteur de champ magnétique. Dans la suite de la description, lorsqu'une valeur de couplage spin-orbite est associée à un matériau, il est important de noter que les valeurs de couplage spin-orbite mentionnées sont basées sur les orbitales 2p des atomes des matériaux cités. Ces valeurs sont utilisées pour faciliter la comparaison entre les matériaux. Cette approche est adoptée pour fournir une référence cohérente et compréhensible dans le cadre de la présente invention.

Dans le mode de réalisation de la figure 1 le dispositif 1 est relié à un premier terminal 41 conducteur. Il s'agit par exemple d'un via conducteur traversant un substrat 5 et débouchant à la surface de celui-ci. Le premier terminal 41 peut être un via conducteur, par exemple en cuivre, chargé de réaliser le routage dans un circuit intégré, par exemple au niveau d'un bloc fonctionnel de fin de ligne, aussi appelé « backend of line » en anglais. Alternativement, le premier terminal 41 peut être un bouchon (dit « plug » en anglais), par exemple en tungstène, disposé sur le via pour bloquer la diffusion d'espèce telles que le cuivre vers les différents niveaux du backend of line. Le substrat 5 représente par exemple un niveau du backend of line. Le substrat 5 est préférentiellement non conducteur, il s'agit par exemple d'une couche semiconductrice, par exemple en silicium, recouvert par une ou plusieurs couches diélectriques, par exemple en oxyde de silicium.

Le substrat 5, et en particulier sa surface, définit un plan {X ; Y} de référence sur lequel sont déposées les différentes couches du dispositif 1. Pour cette raison ce plan est également appelé « plan des couches ». L'axe Z, illustré dans la figure 1 s'étend perpendiculairement au plan des couches {X ; Y} et peut être appelé « verticale ». La même convention d'axes et de plan est considérées sur les figures 2 à 11 sans qu'ils soient pour autant répétés.

Le dispositif 1 représenté dans la figure 1 comprend :
- une jonction tunnel magnétique 10 ;
- un espaceur conducteur 30 ; et
- une piste conductrice 20.

L'espaceur conducteur 30 est disposé entre la jonction tunnel 10 et la piste conductrice 20 pour séparer ces dernières. Dans ce mode de réalisation, la jonction tunnel magnétique 10 repose sur le premier terminal 41 avec lequel elle peut être en contact électrique. L'espaceur 30 repose sur la jonction tunnel 10. Enfin, la piste conductrice 20 repose sur l'espaceur 30.

L'espaceur 30 s'étend dans le prolongement de la jonction tunnel magnétique 10 suivant la verticale Z. L'espaceur 30 et la jonction 10 sont en l'occurrence délimités par un flanc commun 30, 10a qui est, dans cet exemple, parallèle à la verticale Z. Par « flanc », on entend une surface latérale 30a, 10a délimitant le pourtour de l'espaceur 30 et de la jonction 10. Cette délimitation dans le prolongement est une conséquence d'un mode de fabrication du dispositif 1 et résulte, par exemple, de la délimitation par gravures successives des deux éléments à travers un même masque de gravure. L'empilement de la jonction tunnel 10 et de l'espaceur 30 peut ainsi présenter une forme pouvant être cylindrique ou ellipsoïdale ou parallélépipédique et dont une base repose sur le premier terminal 41.

La jonction tunnel magnétique 10 de la figure 1 comprend une première couche 11 magnétique, dite « couche libre », une deuxième couche 12 non-magnétique et isolante, dite « barrière tunnel » et une troisième couche 13 magnétique dite « couche de référence ». Les couches magnétiques 11, 13 s'étendent parallèlement au plan des couches.

La couche libre 11 s'étend parallèlement au plan des couches {X ; Y}. Elle présente une aimantation et une anisotropie magnétique. L'anisotropie de la couche libre 11 est configurée pour stabiliser l'aimantation selon au moins deux configurations distinctes. Par exemple, l'anisotropie de la couche libre 11 peut orienter spontanément (et en l'absence de champ externe) l'aimantation hors du plan des couches {X ; Y} et préférentiellement perpendiculairement au plan des couches {X ; Y} (on parle alors d'anisotropie magnétique perpendiculaire). Elle peut alors être dirigée parallèlement ou antiparallèlement à la verticale Z. Alternativement, l'anisotropie de la couche libre 11 peut également être telle que l'aimantation s'oriente spontanément dans le plan des couches {X ; Y}. L'aimantation peut également adopter une configuration de vortex ou de skyrmion ayant une polarité hors du plan des couches (c'est-à-dire un moment magnétique net hors du plan des couches).

La couche libre 11 peut être réalisée à partir de Fe, Co, Ni ou d'un alliage de ces éléments, par exemple CoFe, CoFeB ou encore en NiFe.

La couche de référence 13 présente également une aimantation, dite « aimantation de référence », et une anisotropie. L'anisotropie de la couche de référence 13 est préférentiellement configurée pour que l'aimantation de référence présente une configuration prédéterminée, par exemple selon une direction fixée et orientée dans le plan des couches {X ; Y} ou orientée hors de ce plan. L'anisotropie de la couche de référence 13 est préférentiellement telle que l'aimantation de référence conserve sa configuration pendant toute la durée de vie ou d'utilisation de du dispositif 1. Pour cela, la jonction tunnel 10 peut comprendre une couche antiferromagnétique (non représentée dans la figure 1), couplée à la couche de référence 13, pour renforcer l'anisotropie de la couche de référence 13. Il peut s'agir d'une multicouche de couches ferromagnétiques couplées les unes aux autres de manière antiparallèle, dite « couche antiferromagnétique synthétique » ou « SAF » pour « Synthetic Antiferromagnet » en anglais.

La couche de référence 13 peut également être réalisée à partir de Fe, Co, Ni ou d'un alliage de ces éléments, tels que ceux précités pour la couche libre 11, ou à partir d'une multicouche comprenant par exemple des alternances de Co et de Pt

La barrière tunnel 12 est configurée pour induire un effet tunnel lors de la circulation d'une courant d'électrons dans la jonction tunnel 10. Ce courant est par exemple utilisé pour mesurer la configuration de l'aimantation de la couche libre 11 par rapport à l'aimantation de la couche de référence 13. La barrière tunnel 12 est une couche isolante et non-magnétique. Elle sépare la couche libre 11 de la couche de référence 13 et s'étend préférentiellement au contact de ces deux couches 11, 13. Elle peut être réalisée à partir d'oxyde, de nitrure ou d'une combinaison d'oxydes et de nitrures. Par exemple, il peut s'agir de MgO, de MgAlxOy, de AlOx, de TiOx, de HfOx, de TaOx, de AIN, ou ZnO

La forme des couches libre 11 et de référence 13 peut contribuer à l'anisotropie magnétique de ces couches pour orienter leurs aimantations hors du plan des couches ou au contraire dans le plan des couches. Dès lors, la délimitation de la jonction tunnel 10 peut avoir un impact important sur l'anisotropie des couches résultantes. La barrière tunnel 12 peut également contribuer à l'anisotropie magnétique de la couche libre 11 et/ou de la couche de référence. Lorsqu'elle est constituée de MgO, elle peut induire une anisotropie interfaciale hors plan au contact de couches en CoFe ou de CoFeB. Cette anisotropie interfaciale est avantageusement utilisée pour orienter l'aimantation de la couche libre 11 hors du plan des couches {X ; Y}.

La jonction tunnel magnétique 10 permet au dispositif 1 de fonctionner comme une mémoire magnétique non-volatile ou comme un capteur de champ magnétique. Le contact direct de l'espaceur 30 (ou de la couche de conversion) avec la couche libre 11 permet d'appliquer un couple sur l'aimantation de cette dernière.

La jonction tunnel 10 peut également comprendre des couches supplémentaires, non-représentées sur la figure 1. Il s'agit par exemple d'une couche d'adaptation, aussi appelée « seed layer » en anglais, permettant de privilégier un réseau cristallin lors de la croissance des couches formant la jonction tunnel 10. Elle peut être réalisée en Ta, Pt, Wou encore en MgO.

Dans le mode de réalisation de la figure 1, le dispositif 1 est dans une configuration (ou agencement) dite « bottom pinned ». La jonction tunnel 10 est disposée entre le substrat 5 et l'espaceur 30. Plus précisément, cette configuration peut correspondre à l'agencement des couches magnétiques 11, 13 de la jonction tunnel 10, qui peuvent avoir une influence sur l'agencement de l'espaceur 30 et de la piste conductrice 20. Dans une configuration bottom pinned, la jonction tunnel 10 repose sur la couche de référence 13. C'est-à-dire que la couche de référence 13 est disposée entre la couche libre 11 et le substrat 5. La couche libre 11 est donc disposée sur le dessus de la jonction tunnel 10, au niveau de laquelle repose l'espaceur 30.

La configuration bottom-pinned présente un avantage lors de la délimitation de la jonction tunnel 10 et en particulier de la couche isolante par gravure. En effet, dans une configuration inversée (dite « top pinned »), la couche libre 11 est généralement peu épaisse et se situe proche du substrat 5 sous-jacent. Lors de sa gravure, des résidus de gravures peuvent se déposer sur les parois de la jonction 10 et court-circuiter la barrière tunnel 12. En revanche, dans la configuration bottom-pinned, la couche de référence 13 est généralement plus épaisse et éloigne la barrière tunnel du substrat 5 sous-jacent. Le risque de court-circuit de la barrière tunnel est moindre.

L'espaceur 30 est un conducteur non-magnétique. Il s'étend dans le prolongement de la jonction tunnel 10, selon la verticale Z, pour séparer la piste conductrice 20 de la jonction tunnel 10. Il permet ainsi de fabriquer la jonction tunnel 10 et la piste conductrice 20 dans des étapes distinctes sans compromettre la jonction 10 ou la piste 20. Il est également adapté pour transférer un courant de moments orbitaux généré par la piste 20 jusqu'à la jonction tunnel 10 de manière à pouvoir contrôler une aimantation de cette dernière.

L'espaceur 30 comprend au moins deux faces, opposées l'une à l'autre. L'une des deux faces correspond au sommet de l'espaceur 30 (dans le sens croissant suivant la verticale Z). L'autre des deux faces, dite « pied » et opposée au sommet, est en regard de la jonction tunnel 10.

La piste conductrice 20 est en contact direct avec le sommet de l'espaceur 30.

L'espaceur 30 peut être en contact direct la jonction tunnel 10 et par exemple avec la couche libre 11 de la jonction 10. Par « contact direct », on entend que l'espaceur 30 et la couche libre 11 partage une interface commune, il n'y a pas de couche intermédiaire. Ainsi, le pied de l'espaceur 30 (opposée au sommet) est en contact direct avec la couche libre 11 de la jonction 10. Ainsi, le courant de moments orbitaux est injecté directement dans la jonction tunnel 10. De plus, le nombre d'interfaces est restreint, permettant de maximiser le courant injecté.

Alternativement, le dispositif 1 peut comprendre une couche de conversion (non représentée sur les figures et discutée plus bas). Dans cette alternative, l'espaceur 30 (et plus particulièrement le pied de l'espaceur 30) peut être séparé de la couche libre 11 par la couche de conversion.

L'espaceur 30 présente une épaisseur h30, mesurée perpendiculairement au plan des couches {X ; Y} (pouvant également être appelée « hauteur »).

L'espaceur 30 présente également une longueur moyenne de diffusion de moments orbitaux δ₃₀. La longueur moyenne de diffusion de moments orbitaux δ (que l'on appellera également « longueur moyenne de diffusion ») correspond à une longueur qu'un courant de moments orbitaux peut parcourir dans un matériau avant d'être significativement absorbé. La longueur moyenne correspond à une moyenne de la longueur de diffusion sur le volume de l'espaceur 30.

Afin d'agir sur l'aimantation de la couche libre 11, il est nécessaire que l'espaceur 30 puisse transférer une partie substantielle du courant de moments orbitaux généré par la piste 20 jusqu'à la jonction tunnel 10 et en particulier jusqu'à la couche libre 11. Pour cela, la longueur de diffusion δ₃₀ de l'espaceur 30 est strictement supérieure à l'épaisseur h30 de l'espaceur 30. Autrement dit, en limitant l'épaisseur h30 de l'espaceur 30 à une valeur inférieure à la longueur moyenne de diffusion de moments orbitaux δ, une partie du courant de moments orbitaux induit par la piste conductrice 20 est effectivement transférée à la jonction tunnel 10.

La longueur moyenne de diffusion de l'espaceur 30 est strictement supérieure à 10 nm. De la sorte l'épaisseur de l'espaceur 30 peut atteindre 10 nm voire plus, dans la limite de la longueur moyenne de diffusion. Une épaisseur h30 supérieure ou égale à 10 nm garantit une distance suffisante entre la jonction tunnel 10 et le sommet de l'espaceur 30, pour pouvoir former la piste conductrice, même avec des étapes de fabrications agressives et sans risquer de détériorer la jonction tunnel 10. Elle réduit également le risque de migration d'une espèce de la piste conductrice 20 vers la jonction tunnel 10 ou inversement. Plus grande est l'épaisseur h30 de l'espaceur 30 et plus bas est le risque de détérioration ou de migration.

Préférentiellement la longueur moyenne de diffusion de l'espaceur est supérieure ou égale à 20 nm voire supérieure ou égale à 50 nm voire supérieure ou égale à 100 nm afin d'obtenir un espaceur 30 présentant une forte épaisseur, par exemple supérieure à 100 nm.

L'espaceur 30 présente également un couplage spin-orbite faible. Ainsi, la propagation des courants de moments orbitaux jusqu'à la jonction 10 n'est que faiblement perturbée par des courants de spins. Par faible couplage spin-orbite, on entend un couplage inférieur à 136 eV, soit 10 Ry (l'unité Rydberg, couramment utilisée pour exprimer le couplage spin-orbite, est égale à 13,6 eV). De manière préférée, le couplage spin-orbite de l'espaceur 30 est inférieur à 13,6 eV soit 1 Ry.

Les matériaux offrant un couplage spin-orbite faible et une longueur de diffusion importante sont par exemple : le titane, le vanadium, le chrome, le manganèse, le cuivre, le zirconium, le niobium, le molybdène, le ruthénium, l'aluminium, le silicium polycristallin, le tungstène en phase alpha (dit « α-W », à différencier de la phase béta dite « β-W » qui présente un couplage spin-orbite trop important). L'espaceur 30 peut donc être formé à partir d'un de ces matériaux ou d'un alliage de ces matériaux. Il est également intéressant, pour faciliter la fabrication du dispositif 1, de réaliser l'espaceur 30 à partir d'un nitrure de ces matériaux ou à partir d'un alliage durci de ces matériaux.

Les matériaux titane et nitrure de titane présentent l'avantage d'être fréquemment utilisés pour former des masques durs, leur emploi est donc maitrisé.

L'espaceur 30 présente la particularité d'être placé sur les chemins permettant de réaliser l'écriture et la lecture dans le dispositif 1. En effet, il est disposé sur le chemin de courant de moments orbitaux, lors de l'écriture, et sur le chemin de courant polarisé en spin traversant la jonction 10 lors de la lecture. L'espaceur 30 est alors avantageusement choisi pour présenter une conductivité électrique élevée, égale ou avantageusement supérieure à celle de la piste conductrice 20. Elle est par exemple supérieure ou égale à 10³ S/m voire préférentiellement supérieure à 10⁴ S/m.

Les moments orbitaux ne permettant pas de réaliser directement un couple sur l'aimantation de la jonction 10. L'un des deux mécanismes suivants peut être requis. L'action des moments orbitaux sur l'aimantation peut être due à un entrelacement des moments orbitaux avec les moments de spins (dit « spin-orbital entanglement » en anglais) et/ou une partie du courant de moments orbitaux est converti en courant de spins la jonction 10, ces derniers appliquant un couple sur une aimantation de la jonction 10. L'intérêt de tels mécanismes est qu'ils ne sont pas localisés au voisinage immédiat de l'interface entre l'espaceur 30 et la jonction 10. Les moments orbitaux peuvent se propager dans le volume des couches magnétique et créer un couple dans le volume de ces couches. À noter que les matériaux magnétiques peuvent également présenter un couplage spin-orbite important tendant également à générer un courant de spins à partir d'une partie du courant de moments orbitaux. Ce courant de spin peut alors appliquer directement un couple sur l'aimantation de l'empilement.

Dans une variante non illustrée, le dispositif 1 peut comprendre une couche, dite « couche de conversion » dont le rôle est de convertir une partie du courant de moments orbitaux en courant de spins. Cette couche de conversion est par exemple réalisée à partir d'un matériau présentant un couplage spin-orbite élevé (c'est à dire supérieur à 680 eV, soit 50 Ry). Placée sur le chemin des courants de moments orbitaux, la couche de conversion convertit tout ou partie du courant de moments orbitaux en courant de spins qui peuvent ainsi appliquer un couple sur l'aimantation. La couche de conversion peut être placée à n'importe quel endroit entre la piste conductrice 20 et la jonction tunnel 10. Toutefois il est préférable qu'elle soit placée entre l'espaceur 30 et la jonction tunnel 10. Ainsi, la conversion est réalisée juste avant que les courants de moments orbitaux et de spins ne pénètrent dans la jonction tunnel 10. De plus, l'espaceur 30 peut présenter une longueur de diffusion de spin qui peut être inférieure à la longueur de diffusion de moments orbitaux. En outre, entre l'espaceur 30 et la jonction tunnel 10, la couche de conversion est également protégée par l'espaceur 30, de la même façon que la jonction tunnel. Les états de surface de la couche de conversion sont alors optimaux.

La couche de conversion s'étend par exemple parallèlement au plan des couches et contre la jonction tunnel 10. L'espaceur 30 s'étend contre la couche de conversion.

La couche de conversion est préférentiellement réalisée à partir d'un matériau présentant un couplage spin-orbite fort, c'est-à-dire supérieur ou égal à 680 eV, soit 50 Ry. Cette couche de conversion est par exemple réalisée à partir d'un métal lourd tel que le platine ou le carbure de tungstène dans sa phase béta (notée « β-W »). Les matériaux présentant un couplage spin-orbite élevé présentent généralement une conductivité électrique faible, par exemple de l'ordre de 10² S/m voire moins. Afin de conserver une résistance électrique faible au sein du dispositif 1, la couche de conversion est préférentiellement fine, c'est-à-dire d'une épaisseur inférieure à 10 nm. Lorsqu'elle est en platine, elle présente par exemple une épaisseur de 8 nm. Lorsqu'elle est en β-W, elle présente par exemple une épaisseur de 4 nm.

La piste conductrice 20 s'étend sur l'espaceur 30 et au contact direct de cet espaceur 30. Dans cet exemple, elle s'étend entièrement parallèlement au plan des couches {X ; Y} en débordant sur la couche diélectrique 90 entourant l'espaceur 30. Autrement dit, le dispositif 1 présente une forme de T, reposant sur le premier terminal 41 avec lequel il peut être connecté électriquement.

La piste conductrice 20 est au contact direct de l'espaceur 30 et en particulier directement contre le sommet de l'espaceur 30. Ainsi, l'espaceur 30 sépare la jonction 10 de la piste 20 et réalise un contact électrique entre les deux (soit directement entre la jonction 10 et la piste 2, soit au moyen de la couche de conversion).

La piste conductrice 20 est connectée à deux terminaux conducteurs 42, 43 permettant la circulation d'un courant électronique dans la piste 20.

La piste conductrice 20 est configurée pour, lorsqu'elle est parcourue par un courant électrique, induire un courant de moments orbitaux dans l'espaceur 30. Le courant de moments orbitaux est à différencier d'un courant de spins ou d'un courant d'électrons polarisés en spin. Il s'agit, dans le cas présent, d'un courant impliquant le déplacement de charges sous la forme de moments orbitaux. Dans l'exemple de la figure 1, la direction des moments orbitaux est matérialisée par les croix cerclées. La circulation d'un courant électrique longitudinal dans la piste conductrice 20, c'est-à-dire parallèlement au plan des couches {X ; Y}, génère un courant de moments orbitaux transversal, c'est à dire perpendiculairement au plan des couches. La direction de propagation du courant de moments orbitaux est matérialisée par la flèche épaisse dans la figure 1. Grâce au contact direct entre la piste 20 et l'espaceur 30, le courant de moments orbitaux se propage dans l'espaceur 30, en direction de la jonction tunnel 10.

La piste conductrice 20 est réalisée à partir d'un matériau apte à générer un courant de moments orbitaux à partir d'un courant de charges électriques. En particulier, il est préféré le matériau considéré présente un taux de conversion du courant de charges en courant de moments orbitaux suffisant. Le taux de conversion des charges en moments orbitaux est donné par unité de courant et est donc sans dimension. Il est préférable d'utiliser des matériaux pour lesquels le taux de conversion en courant de moments orbitaux à partir d'un courant de charges électriques est supérieur à 1% et préférentiellement supérieur ou égal à 10%, voire supérieur ou égale à 50 % et de manière encore préférée supérieur ou égal à 100 %, voire au-delà.

La piste 20 est également réalisée dans un matériau conducteur, c'est à dire présentant une conductivité électrique supérieure à 10³ S/m, voire supérieure ou égale à 10⁴ S/m, voire supérieure ou égale à 5.10⁴ S/m. De la sorte, les pertes résistives du dispositif 1 sont faibles. La piste conductrice 20 peut donc être utilisée pour réaliser une lecture de la configuration magnétique de la jonction tunnel 10, par exemple par transfert de spin. Une faible résistance de la piste conductrice 20 permet également d'améliorer la vitesse de lecture du dispositif 1.

La piste conductrice 20 présente une épaisseur h20, mesurée perpendiculairement au plan des couches {X ; Y}, préférentiellement importante. En effet, l'efficacité de conversion du courant de charge en courant de moments orbitaux augmente avec l'épaisseur h20 de la piste conductrice 20. La piste conductrice 20 permet ainsi de générer un courant de moments orbitaux important. À l'inverse, les pistes utilisées pour générer des courants de spins (dites « pistes SOT ») présentent généralement des épaisseurs faibles, par exemple inférieure à 10 nm. L'efficacité de conversion d'une piste conductrice 20 selon l'invention (c'est à dire épaisse), pour générer des courants de moments orbitaux, est donc être dix à cent fois supérieure à celle d'une piste SOT.

De plus, une épaisseur plus élevée permet de réduire la résistance totale de la piste conductrice 20 et donc augmenté la vitesse de lecture du dispositif 1.

L'épaisseur h20 de la piste conductrice 20 du dispositif 1 est préférentiellement strictement supérieure à 10 nm et préférentiellement supérieure ou égale à 20 nm voire supérieure ou égale à 50 nm. Il est d'ailleurs envisageable et très avantageux que l'épaisseur h20 de la piste 20 soit égale à 100 nm.

Afin que les courants de moments orbitaux générés par la piste 20 puissent atteindre l'espaceur 30, il est avantageux que la piste 20 présente également une longueur moyenne de diffusion de moments orbitaux δ₂₀ (aussi dite « longueur de diffusion moyenne ») suffisante. Il est par exemple préféré que cette longueur de diffusion δ₂₀ soit supérieure ou égale à l'épaisseur h20 de la piste 20. Dès lors, la totalité du courant de moments orbitaux générée peut atteindre l'espaceur 30. Toutefois, si cette longueur δ₂₀ est inférieure à l'épaisseur h20 de la piste 20, une portion seulement de ce courant de moments orbitaux est susceptible d'atteindre l'espaceur 30. Cette portion est proportionnelle à δ₂₀/h20.

La piste conductrice 20 présente également préférentiellement un couplage spin-orbite faible. Ainsi, la génération et la propagation des courants de moments orbitaux dans la piste 20 n'est que faiblement perturbée par des courants de spins. Par faible couplage spin-orbite, on entend un couplage inférieur à 136 eV, soit 10 Ry (l'unité Rydberg, couramment utilisée pour exprimer le couplage spin-orbite, est égale à 13,6 eV) ; et préférentiellement inférieur à 13,6 eV, soit 1 Ry. Les matériaux couramment utilisés pour former les pistes SOT, par exemple les métaux lourds, présentent des couplages spin-orbite dépassant 680 eV, soit 50 Ry. Par exemple, le platine présente un couplage spin-orbite d'environ 1088 eV, soit 80 Ry.

La couplage spin-orbite peut également être exprimé par rapport à un couplage spin-orbite connu pour un matériau usuel. Par exemple, exprimé par rapport au platine, la piste conductrice 20 présente préférentiellement un couplage spin-orbite inférieur à 12 % du couplage spin-orbite du platine, voire inférieur à 1,2 % du couplage spin-orbite du platine.

Les matériaux offrant un taux de conversion intéressant, une conductivité électrique suffisante, un couplage spin-orbite faible et une longueur de diffusion importante sont par exemple : le titane, le vanadium, le chrome, le manganèse, le cuivre, le zirconium, le niobium, le molybdène, le ruthénium, l'aluminium, le silicium polycristallin, le tungstène en phase alpha (dit « α-W », à différencier de la phase béta dite « β-W » qui présente un couplage spin-orbite important). La piste conductrice 20 peut donc être formée à partir d'un de ces matériaux ou d'un alliage de ces matériaux. Il est également intéressant, pour faciliter la fabrication du dispositif 1, de réaliser la piste conductrice 20 à partir d'un nitrure de ces matériaux ou à partir d'un alliage durci de ces matériaux.

La piste conductrice 20 est en contact direct avec l'espaceur 30 afin d'injecter efficacement le courant de moments orbitaux dans l'espaceur 30. Il est avantageux que la piste conductrice 20 et l'espaceur 30 partage donc une interface commune grande et de bonne qualité. L'espaceur 30 et la piste 20 peuvent avantageusement être réalisé à partir d'un même matériau afin de réduire les effets d'interface. Ils peuvent également être déposés successivement, par exemple sous vide ou atmosphère neutre, afin de conserver un état de surface optimal entre l'espaceur 30 et la piste 20.

La figure 2 présente schématiquement un deuxième mode de réalisation du dispositif 1. À la différence du mode de réalisation de la figure 1, la piste conductrice 20, ne s'étend pas parallèlement au plan des couches {X ; Y}. Elle présente au contraire une forme en L (pouvant également être dans une alternative en double L, autrement dit en U). La piste conductrice 20 présente deux portions consécutives. Une première portion 21, dite « portion parallèle », s'étendant perpendiculairement au plan des couches {X ; Y} et au contact direct de l'espaceur 30. Une deuxième portion 22, dite « portion perpendiculaire » s'étendant perpendiculairement au plan des couches {X ; Y}, autrement dit selon la verticale Z. Dans cet exemple, la portion perpendiculaire 22 s'étend dans le prolongement d'un flanc 30a de l'espaceur 30. Elle pourrait également être latéralement distante de l'espaceur 30.

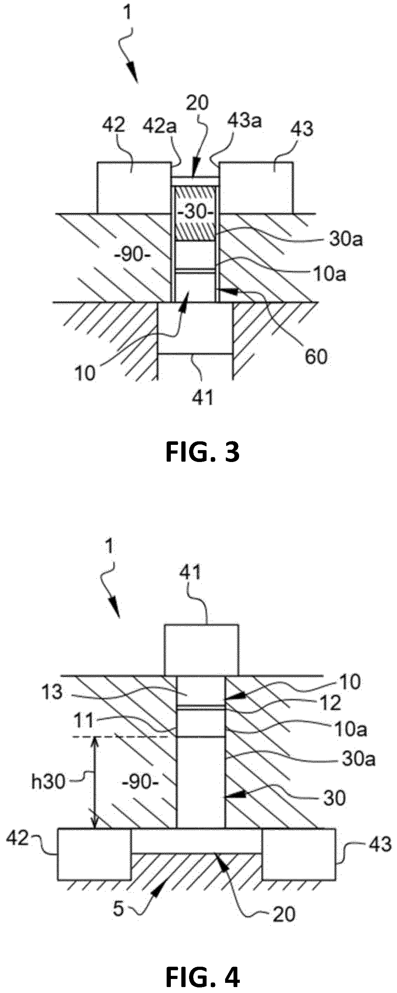

La figure 3 présente schématiquement un troisième mode de réalisation du dispositif 1. À la différence du mode de réalisation de la figure 1, les deuxième et troisième terminaux 42, 43 encadrent le sommet de l'espaceur 30 afin de raccourcir la longueur de la piste conductrice 20. Dans cet exemple, l'espaceur 30 comprend une couche électriquement isolante 60 s'étendant contre son flanc 30a. La couche isolante 60 a pour objectif d'isoler électriquement l'espaceur 30 des deuxième et troisième terminaux 42, 43. Ainsi les terminaux 42, 43 sont uniquement connectés à la piste conductrice 20. La couche isolante 60 peut recouvrir une portion seulement du flanc 30a de l'espaceur 30. Il s'agit au moins de la portion de flanc en regard des deuxième et troisième terminaux 42, 43. La couche isolante peut également s'étendre contre le flanc 10a de la jonction tunnel 10, dans le prolongement du flanc 30a de l'espaceur 30.

La couche isolante 60 peut être formée par oxydation du flanc 30a de l'espaceur 30. Elle peut également être formée par dépôt conforme d'un diélectrique ou par dépôt conforme d'un semiconducteur qui est oxydé par la suite. Il faut toutefois veiller à protéger la surface supérieure de l'espaceur 30 sur laquelle la piste conductrice 20 prend contact. Pour cela, la couche isolante 60 peut être formée après la formation de la piste conductrice 20.

Dans l'exemple illustré par la figure 3, les deuxième et troisième terminaux 42, 43, plaqués contre l'espaceur 30 (et en l'occurrence contre la couche isolante 60), forment une cavité (ou tranchée) au fond de laquelle s'étend la piste conductrice 20, connectant les deux terminaux. Chacun des terminaux 42, 43 présente une paroi 42a, 43a s'étendant dans le prolongement d'une partie du flanc 30a de l'espaceur 30. Ces parois 42a, 43a forment ainsi les parois de la cavité (ou de la tranchée).

Alternativement, les deux terminaux 42, 43 peuvent être disposés de part et d'autre de l'espaceur 30, en affleurant le sommet l'espaceur 30. La piste conductrice 20 s'étend alors de manière plane sur les deux terminaux 42, 43 et le sommet de l'espaceur 30.

La figure 4 présente un mode de réalisation dans lequel le dispositif 1 est dans une configuration dite « top pinned ».

À la différence du mode de réalisation de la figure 1, dans lequel le dispositif 1 est dans une configuration dite « bottom pinned », l'espaceur 30 est disposé entre la jonction tunnel 10 est le substrat 5. Dans une configuration top pinned, la jonction tunnel 10 repose sur l'espaceur 30 par sa couche libre 11. C'est-à-dire que la couche de référence 13 est disposée au-dessus de la couche libre 11.

Dans cet exemple, la piste conductrice 20 et l'espaceur 30 sont formés dans un même matériau. L'absence d'interface entre les deux matériaux permet d'améliorer l'efficacité du dispositif 1.

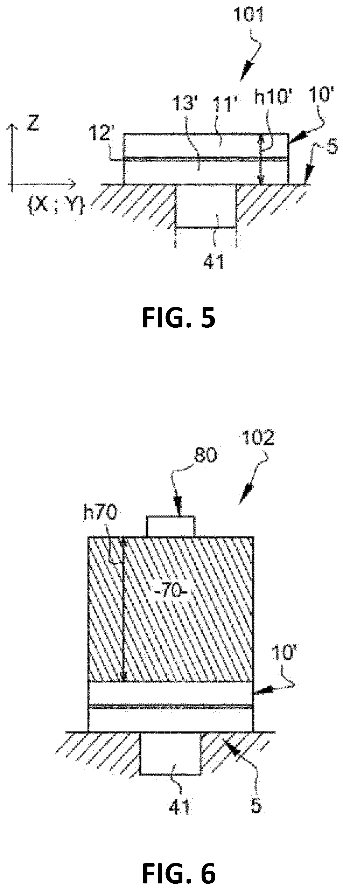

Les figures 5 à 10 présentent schématiquement un mode de mise en œuvre d'un procédé de fabrication permettant d'obtenir le dispositif 1 de la figure 1, c'est-à-dire dans une configuration bottom pinned. Le procédé de fabrication peut être réalisé à partir d'un substrat 5, tel que présenté dans la figure 5, dont une surface supérieure forme le plan des couches {X ; Y}. Le substrat 5 est par exemple en Si. Dans ce mode de mise en œuvre, un premier terminal 41 traverse en partie le substrat 5 et débouche sur sa surface par une ouverture. Le sommet du premier terminal 41 affleure la surface supérieure du substrat 5. Le premier terminal 41 peut être un via, un bouchon de type « BEOL » (pour « Back End Of Line » en anglais) ou encore d'une piste s'étendant en partie dans le substrat 5.

Une première étape du procédé, illustré par la figure 4, consiste à déposer 101 un empilement magnétique 10' sur le substrat 5. Cet empilement comprend des première, deuxième et troisième couches 11', 12', 13' qui sont destinées à former les couches 11, 12, 13 de la jonction tunnel 10 de la figure 1. Ce dépôt 101 comprend par exemple le dépôt de deux couches magnétiques 11', 13' séparées par une couche isolante 12'. La première couche magnétique 11' est par exemple destinée à former, une fois délimitée, la couche libre 11 de la jonction tunnel 10.

Le procédé peut également comprendre un dépôt initial de couches destinées à former une couche seed et/ou un antiferromagnétique synthétique (non représentées dans cette figure), tel que discutées précédemment.

Le procédé comprend ensuite le dépôt 102 d'une couche conductrice destinée à former l'espaceur 30, illustrée par la figure 5. La couche conductrice 70 peut être formée d'un seul matériau (ou alliage de matériaux). En d'autres termes, elle ne comprend pas de sous-couche ou d'inclusions. Dans ce cas, la couche conductrice 70 comprend un matériau offrant une grande longueur de diffusion de courant de moments orbitaux, telle que discutée plus haut. Ce matériau présente également un matériau dont le couplage spin-orbite est strictement inférieur à 136 eV, soit 10 Ry, voire 13,6 eV, soit 1 Ry. La couche conductrice 70 est par exemple réalisée à partir des matériaux décrits en référence à l'espaceur 30.

Dans cet exemple, la couche conductrice 70 est déposée directement au contact de l'empilement magnétique 10' et plus particulièrement de la première couches magnétique 11'. Dans ce cas, le dépôt 102 peut être réalisé au moyen d'une méthode de dépôt par voie physique. D'autres méthodes de dépôt peuvent être envisagées, telles qu'un dépôt par voie chimique.

Alternativement, avant le dépôt de la couche conductrice 70, le procédé de fabrication peut comprendre une étape de dépôt, sur l'empilement magnétique 10', d'une couche de faible épaisseur (inférieure à 10 nm) et présentant un fort couplage spin-orbite, supérieure à 680 eV, soit 50 Ry, de manière à former, après délimitation, une couche de conversion. La couche conductrice 70 est alors déposée ensuite directement au contact de cette couche, destinée à former la couche de conversion.

L'empilement 10' et la couche conductrice 70 (et la couche de conversion s'il y a lieu) sont avantageusement déposés dans des étapes successives. Ainsi, l'état de surface de la première couche magnétique 11', fraichement déposée, peut être protégé par la couche conductrice 70 (ou la couche de conversion). L'atmosphère dans laquelle sont déposées ces différentes couches est ainsi conservée. Les dépôts sont par exemple réalisés sous vide ou dans une atmosphère de gaz neutre, sans remise à l'air entre ces dépôts. Ainsi, la qualité de l'état de surface de la première couche magnétique 11' est conservée et protégée par la couche conductrice 70. Ce dépôt permet ainsi de garantir une interface entre la couche libre 11 de la jonction tunnel 10 et l'espaceur 30 de très bonne qualité.

Le procédé peut comprendre un recuit, réalisé après les dépôts 101, 102 de l'empilement magnétique 10' et de la couche conductrice 70. Par exemple, lorsque la première couche magnétique 11' de l'empilement 10' est en CoFeB et la couche isolante 12' en MgO, le recuit permet d'améliorer l'interface entre ces deux couches et augmenter l'anisotropie magnétique hors plan entre ces deux couches 11', 12'. Il peut en résulter, après délimitation de la jonction, une couche libre 11 présentant une anisotropie perpendiculaire. Le recuit peut également améliorer l'interface entre la première couche magnétique 11' et la couche conductrice 70. Le recuit peut également être réalisé après gravure de la couche conductrice 70 et de l'empilement magnétique 10'.

La figure 6 présente une étape de gravure 103 de la couche conductrice 70 de manière à former l'espaceur 30. Cette gravure est réalisée de manière anisotrope à travers un premier masque de gravure 80. La gravure 103 peut être arrêtée sur l'empilement magnétique 10'. Le premier masque 80, par exemple en résine, et formé par photolithographie sur l'espaceur 30.

La gravure 103 de la couche conductrice 70 est avantageusement alignée avec le premier terminal 41 de sorte que le dispositif 1 soit correctement connectée au terminal 41.

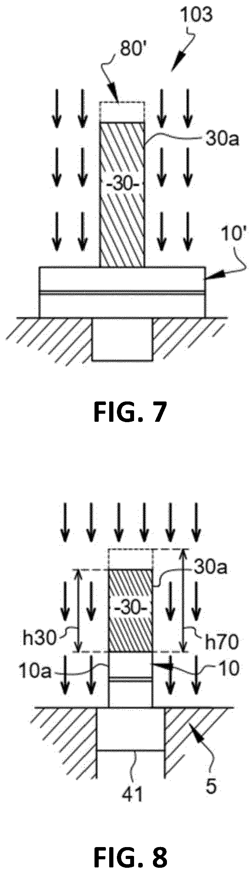

La figure 7 présente une étape 104 de gravure de l'empilement magnétique 10' de manière à former la jonction tunnel 10. Cette délimitation 104 est réalisée par gravure anisotrope en employant l'espaceur 30 obtenu dans l'étape précédente. La gravure est arrêtée sur le substrat 5. L'empilement 10' est ainsi gravé dans le prolongement de l'espaceur 30. La gravure permet de conserver une très bonne qualité d'interface entre la première couche magnétique 11' (formant maintenant la couche libre 11) et l'espaceur 30.

À l'issue de l'étape de gravure 104 de l'empilement magnétique 10', l'espaceur 30 présente son épaisseur finale h30. L'épaisseur initiale h70 de la couche conductrice 70 est avantageusement choisie pour que l'espaceur 30 présente la bonne épaisseur finale h30 à la fin de la gravure. Ainsi, les courants de moments orbitaux peuvent atteindre la jonction tunnel 10.

La couche conductrice 70 est déposée avec une épaisseur initiale h70, mesurée perpendiculairement au substrat 5. Cette épaisseur h70 dépend de la vitesse de gravure du matériau utilisé pour former cette couche 70 ainsi que la vitesse de gravure de l'empilement magnétique 10'. De manière générale, par « vitesse de gravure », on entend une vitesse à laquelle est gravée une couche. Cette vitesse de gravure s'apprécie dans des conditions reproductibles de gravure. La comparaison entre deux vitesses de gravure est donc réalisée pour des conditions identiques de gravure. En effet, la vitesse de gravure dépend fortement de l'espèce ou des espèces utilisées comme élément de gravure ou de la composition des fluides ou gaz utilisés pour réaliser la gravure. De plus, comme l'empilement magnétique 10' peut comprendre des couches dont les vitesses de gravures sont différentes, la vitesse de gravure considérée est la vitesse moyenne des vitesses de gravures des couches de l'empilement 10'.

Plus particulièrement, l'épaisseur initiale h70 de la couche conductrice 70 peut dépendre de :
- la vitesse de gravure v70 de la couche conductrice 70 (et notamment de la vitesse moyenne de gravure si celle-ci n'est pas homogène) ;
- la vitesse de gravure v10' et l'épaisseur h10' de l'empilement 10' ; et
- la longueur moyenne de diffusion de l'espaceur 30 (qui peut correspondre à la longueur de diffusion de la couche conductrice 70).

L'épaisseur initiale h70 peut être sensiblement égale à : h70 ≈ h10' × v70/v10' + h30

Par « sensiblement égale » ou le signe « ≈ », on entend égale à 20 % près, voire 10 % prés.

Puisque l'épaisseur h30 de l'espaceur 30 doit être inférieure à la longueur de diffusion δ pour permettre un effet sur la couche libre, l'épaisseur initiale h70 de la couche conductrice est de préférence inférieure à : h70 < h10' × v70/v10' + δ

De cette manière, l'épaisseur finale h30 de l'espaceur 30 garantit la propagation du courant de moments orbitaux généré par la piste conductrice 20 vers la jonction tunnel 10. La vitesse de gravure peut varier au sein de la couche conductrice en fonction de son épaisseur (par exemple lorsqu'il s'agit d'une multicouche). Ainsi, calculer l'épaisseur initiale h70 de la couche conductrice 70 pour obtenir une épaisseur finale h30 de l'espaceur 30 inférieure à la longueur moyenne de diffusion de moments orbitaux garantit le bon fonctionnement du dispositif 1 fabriqué.

Cette inégalité considère qu'à l'issue de la gravure 103 de la couche conductrice 70, le premier masque 80 est complètement retiré. Si un reliquat de du premier masque est conservé après cette étape, les vitesses de gravure et/ou hauteur de la couche conductrice 70 sont avantageusement ajustées pour tenir compte de ce reliquat.

À l'issue de sa délimitation, les couches magnétiques 11 et 13 de la jonction tunnel 10 peuvent présenter leurs anisotropies finales, par exemple perpendiculaire ou planaire.

Afin de limiter la hauteur initiale h70 de l'espaceur 30, pour éviter le risque d'effondrement de ce dernier lors de la gravure, il est avantageusement choisi plus dur que l'empilement magnétique 10'. Par plus « dur », on entend qu'il présente une vitesse de gravure inférieure à la vitesse de gravure de l'empilement magnétique 10'. Ainsi, l'empilement magnétique 10' est gravé plus rapidement que l'espaceur 30 et la couche conductrice peut présenter une épaisseur initiale h70 proche de l'épaisseur finale h30 de l'espaceur 30.

De plus, la forme de l'espaceur 30, et en particulier sa largeur ou son diamètre, mesuré parallèlement au plan des couches {X ; Y}, est mieux contrôlé lorsque la couche conductrice présente une épaisseur initiale h70 moins élevée, proche de l'épaisseur finale h30 de l'espaceur 30. Ainsi, la couche conductrice 70 présente préférentiellement une vitesse de gravure inférieure à 90% de la vitesse de gravure de l'empilement magnétique 10', voire inférieure à 50% de la vitesse de gravure de l'empilement magnétique 10 et de manière encore préférée, inférieure à 20% de la vitesse de gravure de l'empilement magnétique 10'.

La couche conductrice 70 peut être réalisée dans un alliage durci de titane, de vanadium, de chrome, de manganèse, de cuivre, de zirconium, de niobium, de molybdène, de ruthénium, d'aluminium, de silicium polycristallin, ou encore de tungstène α-W. Il peut également s'agit d'un nitrure de ces matériaux.

Avantageusement, la couche conductrice 70 est une multicouche comprenant une première sous-couche et une deuxième sous-couche. La première couche s'étend contre l'empilement magnétique 10'. La première sous-couche est dure, c'est-à-dire qu'elle présente une vitesse de gravure inférieure à la vitesse de gravure de l'empilement magnétique 10' et également inférieure à la vitesse de gravure de la deuxième sous-couche. Les vitesses de gravure des première et deuxième sous-couche et de l'empilement magnétique sont considérées pour des conditions de gravure identiques. Ainsi, combiner des vitesses de gravure différentes permet de déposer une couche conductrice 70 présentant une épaisseur initiale h70 qui soit plus faible (avant gravure de l'espaceur ou délimitation de l'empilement magnétique). En effet, la première sous-couche dure permet de réduire la vitesse de gravure de la couche conductrice 70. Ainsi, le risque d'effondrement de l'espaceur 30 avant ou pendant la gravure de l'empilement magnétique 10' est déduit.

Les courants de moments orbitaux peuvent être influencés par la présence d'interfaces. Pour éviter la prolifération d'interfaces, l'épaisseur de la première sous-couche peut être choisie de sorte que la première sous-couche soit totalement retirée à l'issue de la gravure de l'empilement magnétique 10'. La première sous-couche joue ainsi le rôle de masque de gravure temporaire, permettant de réduire la vitesse de gravure de la couche conductrice (voire de l'espaceur 30), sans pour autant rester dans le dispositif 1 final.

La figure 8 présente schématiquement la formation 105 de la piste conductrice 20. Elle comprend dans un premier temps une sous-étape de dépôt d'une couche diélectrique 90 affleurant le sommet de l'espaceur 30 (c'est-à-dire la partie libre de l'espaceur 30). Cette couche diélectrique 90 est par exemple déposée en recouvrant l'espaceur 30. Ensuite la couche diélectrique 90 est aplanie, par exemple au moyen d'un polissage mécanique et/ou chimique avec arrêt sur le sommet de l'espaceur 30. Cette étape permet de libérer le sommet de l'espaceur de la couche diélectrique 90. La couche diélectrique 90 comprend par exemple du SiO₂. Une sous-étape de dépôt du matériau destiné à former la piste conductrice 20 est déposé sur l'espaceur 30 et la couche diélectrique 90. Le dépôt est réalisé à travers un masque ou la couche est gravée à travers un masque, ou encore le matériau peut est reporté pour former la piste conductrice 20.

Dans la figure 8, la piste conductrice 20 s'étend à plat (c'est-à-dire parallèlement au plan des couches), en partie contre l'espaceur 30 et en partie sur la couche diélectrique 90. Cette configuration offre une accumulation de moments orbitaux suffisante sur la surface de la piste conductrice 20 pour permettre leur injection dans l'espaceur 30.

Le matériau utilisé pour former la piste conductrice 20 est apte à générer un courant de moments orbitaux et présente aussi un couplage spin-orbite faible, par exemple inférieur à 136 eV, soit 10 Ry, voire inférieure à 13,6 eV, soit 1 Ry. Elle est par exemple réalisée à partir de titane, de vanadium, de chrome, de manganèse, de cuivre, de zirconium, de niobium, de molybdène, de ruthénium, d'aluminium, de silicium polycristallin, ou encore de tungstène α-W ou d'un alliage de ces matériaux.

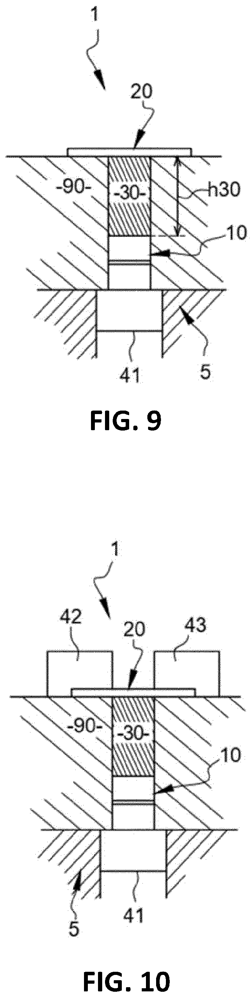

La figure 9 présente schématiquement la formation 106 des deuxième et troisième terminaux 42, 43. Ils sont obtenus par dépôt d'un métal à travers un masque de manière à connecter chacun une extrémité de la piste conductrice 20. Les deuxième et troisième terminaux 42, 43 peuvent également prendre la forme de vias remontant du substrat 5 jusqu'à la piste conductrice 20.

Pour former le dispositif 1 de la figure 2, l'étape de formation de la piste conductrice 20 diffère de l'étape illustrée par la figure 8 en ce que la couche diélectrique 90 n'est pas aplanie par polissage. Elle présente au contraire une différence de hauteur de part et d'autre de l'espaceur 30. La couche diélectrique 90 présente, sur un côté seulement de l'espaceur 30, une hauteur supérieure à celle de l'espaceur 30. La couche diélectrique 90 offre ainsi une surface 91 (ou « flanc »), s'étendant dans le prolongement du flanc 30a de l'espaceur 30, sur laquelle peut s'étendre une portion 22 de la piste conductrice 20. La différence de hauteur de la couche diélectrique 90 est par exemple obtenu par gravure d'une partie de la couche diélectrique 90 avec arrêt sur le sommet de l'espaceur 30 de sorte que la couche diélectrique 90 présente ce flanc 91 s'étendant perpendiculairement au plan des couches {X ; Y} et disposé dans le prolongement d'une partie d'un flanc 30a de l'espaceur 30. La piste conductrice 20 peut ensuite être réalisée par dépôt conforme pour former une première portion 21 s'étendant contre l'espaceur 30 et une deuxième partie 22 s'étendant contre le flanc 91 de la couche diélectrique.

Ainsi, la piste conductrice 20 présente une forme en L avec la portion perpendiculaire 22 qui s'étend au droit de l'espaceur 30 en s'écartant de l'espaceur 30. Elle présente notamment un coin joignant la portion parallèle 21 avec la portion perpendiculaire 22.

Pour former le dispositif 1 de la figure 3, les étapes de formation de la piste conductrice 20 et de formation des deuxième et troisième terminaux 42, 43 sont modifiées et inversées.

Dans un premier temps, le procédé de fabrication comprend une étape supplémentaire de formation de la couche isolante 60 sur le flanc 30a de l'espaceur 30. Cette couche isolante 60 est par exemple obtenue par dépôt conforme d'un film d'oxyde. Elle peut également être obtenue par dépôt conforme d'un film semiconducteur qui est, dans un second temps, oxydé thermiquement. Une gravure anisotrope ou une planarisation chimique et physique de ce film conforme permet de dégager la face supérieure de l'espaceur 30 sur laquelle la piste conductrice 20 doit venir prendre contact.

Dans un second temps, la première sous-étape de formation 105 de la piste conductrice 20 consistant à déposer la couche diélectrique 90 est réalisée de manière à laisser dégager une portion de la hauteur de l'espaceur 30. Autrement dit, la couche diélectrique résultante n'atteint pas et ne dépasse pas le sommet de l'espaceur 30.

Les deuxième et troisième terminaux 42, 43 sont ensuite formés de manière à créer respectivement une première paroi 42a et une deuxième paroi 43a, disposées de part et d'autre de l'espaceur 30 et formant une tranchée à l'aplomb de l'espaceur 30, la portion dégagée de l'espaceur 30 formant un fond de la tranchée. Les deuxième et troisième terminaux 42, 43 sont par exemple formés de part et d'autre de l'espaceur 30, en appui contre la couche isolante 60. Les terminaux 42, 43 sont formés de manière à dépasser l'espaceur 30. En d'autres termes, ils forment les parois 52a, 43a de la tranchée dont l'espaceur 30 est le fond.

Enfin, la deuxième sous-étape de formation 105 de la piste conductrice 20 consistant à déposer le matériau destiné à former la piste conductrice 20 est réalisé dans la cavité formée par les terminaux 42, 43. La piste conductrice 20 s'étend parallèlement au plan des couches {X ; Y} et contre la portion dégagée de l'espaceur 30, en reliant électriquement les premier et deuxième terminaux.

Alternativement, les deuxième et troisième terminaux peuvent être formés à hauteur de l'espaceur 30, c'est-à-dire affleurant le sommet de l'espaceur 30 sur l'espaceur 30 et la couche diélectrique 90. Le dépôt de la piste conductrice 20 permet d'obtenir une piste parallèle au plan des couches.

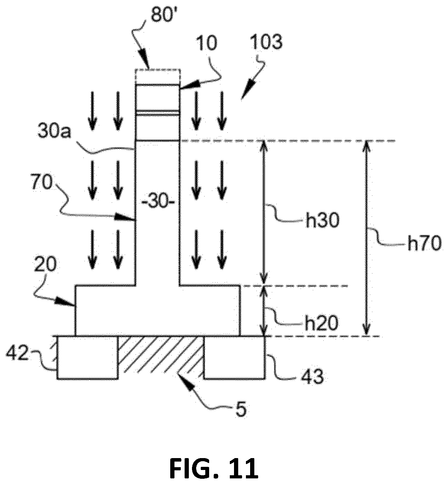

La figure 11 présente schématiquement un mode de mise en œuvre d'un procédé de fabrication permettant d'obtenir le dispositif 1 de la figure 4, c'est-à-dire dans une configuration top pinned. Le procédé de fabrication peut être réalisé à partir d'un substrat 5, tel que présenté dans la figure 5.

Afin d'obtenir la configuration top pinned, c'est-à-dire inverse à la configuration bottom pinned, les étapes du procédé de fabrication sont inversées.

Dans un premier temps, le procédé comprend le dépôt 102 de la couche conductrice 70 sur le substrat 5. Puisque l'espaceur 30 et la piste 20 sont formée à partir de la couche conductrice 70, son épaisseur initiale h70 est égale à la somme de l'épaisseur h30 de l'espaceur 30 visé et de l'épaisseur h20 de la piste conductrice 20. La couche conductrice 70 est réalisé à partir des matériaux précités. Elle doit notamment présenter une couplage spin-orbite moyen strictement inférieur à 136 eV, une longueur moyenne de diffusion de moments orbitaux strictement supérieure à 10 nm et être apte à générer un courant de moments orbitaux à partir d'un courant de charges.

Dans un premier temps, le procédé comprend le dépôt 101 de l'empilement magnétique 10' sur couche conductrice 70. L'empilement magnétique 10' est similaire à l'empilement des figures 5 à 10 hormis le fait que son orientation est renversée par rapport à ces figures. La couche magnétique destinée à former la couche libre 11 est disposée en regard de la couche conductrice 70.

Le procédé comprend ensuite la gravure 104 de l'empilement magnétique 10' pour former la jonction tunnel magnétique 10. Cette gravure peut être formée en employant un masque de gravure.

Le procédé comprend en outre la gravure partielle 103 de la couche conductrice 70 à travers le masque de gravure employé pour graver l'empilement magnétique 10'. Cette gravure partielle 103 permet de délimiter l'espaceur conducteur 30 à l'aplomb de la jonction tunnel 10. Elle permet également de conserver une partie de la couche conductrice 70 formant la piste conductrice 20 en contact direct avec l'espaceur conducteur 30.

Dans une variante, la jonction tunnel 10 peut être employée comme masque de gravure pour réaliser tout ou partie de la gravure partielle 103 de la couche conductrice 70.

## Revendications

1. Dispositif magnétique (1) comprenant : une jonction tunnel magnétique (10) ; un espaceur conducteur (30) ; et une piste conductrice (20), l'espaceur conducteur (30) s'étendant dans le prolongement de la jonction tunnel magnétique (10) selon une direction (Z) perpendiculaire à un plan ({X ; Y}), le plan ({X ; Y}) étant dit « plan des couches », l'espaceur conducteur (30) étant disposé entre la jonction tunnel magnétique (10) et la piste conductrice (20), l'espaceur conducteur (30) étant en contact direct avec la piste conductrice (20), la piste conductrice (20) comprenant au moins une portion s'étendant parallèlement au plan des couches ({X ; Y}) et directement contre l'espaceur conducteur (30), l'espaceur conducteur (30) présentant : un couplage spin-orbite moyen strictement inférieur à 136 eV ; une longueur moyenne de diffusion de moments orbitaux strictement supérieure à 10 nm ; une épaisseur (h30) inférieure à la longueur moyenne de diffusion de moments orbitaux, la piste conductrice (20) étant apte à générer un courant de moments orbitaux à partir d'un courant de charges et présentant un couplage spin-orbite strictement inférieur à 136 eV.

2. Dispositif (1) selon la revendication 1, dans lequel l'espaceur conducteur (30) présente une épaisseur (h30) supérieure ou égale à 20 nm.

3. Dispositif (1) selon l'une des revendications 1 ou 2, dans lequel le couplage spin-orbite moyen de l'espaceur conducteur (30) est strictement inférieur à 13,6 eV.

4. Dispositif (1) selon l'une des revendications 1 à 3, dans lequel la piste conductrice (20) présente une épaisseur (h20) strictement supérieure à 10 nm.

5. Dispositif (1) selon l'une des revendications 1 à 4, dans lequel le couplage spin-orbite moyen de la piste conductrice (20) est strictement inférieur à 13,6 eV.

6. Dispositif (1) selon l'une des revendications 1 à 5, dans lequel la piste conductrice (20) est apte à convertir au moins 10 % du courant de charge en courant de moments orbitaux.

7. Dispositif (1) selon l'une des revendications 1 à 6, comprenant un substrat (5), la jonction tunnel magnétique (10) étant disposée entre l'espaceur conducteur (30) et le substrat (5).

8. Dispositif (1) selon l'une des revendications 1 à 6, comprenant un substrat (5), l'espaceur conducteur (30) étant disposé entre la jonction tunnel magnétique (10) et le substrat (5).

9. Dispositif (1) selon l'une des revendications 1 à 8, dans lequel l'espaceur conducteur (30) est au contact direct de la jonction tunnel magnétique (10).

10. Dispositif (1) selon l'une des revendications 1 à 8, comprenant une couche additionnelle, dite « couche de conversion », présentant un couplage spin-orbite supérieur à 680 eV, disposée entre la jonction tunnel magnétique (10) et l'espaceur conducteur (30), la couche de conversion s'étendant directement contre la jonction tunnel magnétique (10) et directement contre l'espaceur conducteur (30).

11. Dispositif (1) selon la revendication 10, dans lequel la couche de conversion présente une épaisseur strictement inférieure à 10 nm.

12. Procédé de fabrication d'un dispositif magnétique (1) comprenant les étapes suivantes : déposer (101) un empilement magnétique (10') s'étendant parallèlement à un plan ({X ; Y}), dit « plan des couches » et destiné à former, après gravure (104), une jonction tunnel magnétique (10) ; déposer (102) une couche conductrice (70) sur l'empilement magnétique (10') ; graver (103) la couche conductrice (70) de manière anisotrope pour former un espaceur conducteur (30) ; graver (104) l'empilement magnétique (10') pour former une jonction tunnel magnétique (10), la gravure étant réalisée en employant l'espaceur conducteur (30) comme masque de gravure, l'espaceur conducteur (30) présentant, après la gravure de l'empilement magnétique (10') : un couplage spin-orbite moyen strictement inférieur à 136 eV ; une longueur moyenne de diffusion de moments orbitaux strictement supérieure à 10 nm ; et une épaisseur (h30) inférieure à la longueur moyenne de diffusion de moments orbitaux ; et former une piste conductrice (20) au contact direct de l'espaceur conducteur (30) à partir d'un matériau apte à générer un courant de moments orbitaux à partir d'un courant de charges et présentant un couplage spin-orbite strictement à 136 eV, la piste conductrice (20) comprenant au moins une portion s'étendant parallèlement au plan des couches ({X ; Y}) et directement contre l'espaceur conducteur (30).

13. Procédé selon la revendication 12, dans lequel la couche conductrice (70) présente une épaisseur initiale (h70) fonction de : l'épaisseur de l'empilement magnétique (10') ; la vitesse de gravure de l'empilement magnétique (10') ; la vitesse de gravure de la couche conductrice (70) ; et la longueur moyenne de diffusion de moments orbitaux de l'espaceur conducteur (30) après gravure de l'empilement magnétique (10'), la vitesse de gravure de l'empilement magnétique (10') et la vitesse de gravure de la couche conductrice (70) étant considérées pour des conditions de gravure identiques.

14. Procédé selon la revendication 13, selon lequel l'espaceur conducteur (30) présente une vitesse de gravure inférieure à la vitesse de gravure de l'empilement magnétique (10'), les vitesses de gravure de l'espaceur conducteur (30) et de l'empilement magnétique (10') étant considérées pour des conditions de gravure identiques.

15. Procédé selon l'une des revendications 13 ou 14, selon lequel la couche conductrice (70) est une multicouche comprenant une première sous-couche et une deuxième sous-couche, la deuxième sous-couche étant disposée entre la première sous-couche et l'empilement magnétique (10'), la première sous-couche présentant une vitesse de gravure inférieure à la vitesse de gravure de l'empilement magnétique (10') et inférieure à la vitesse de gravure de la deuxième sous-couche, les vitesses de gravure des première et deuxième sous-couches et de l'empilement magnétique (10') étant considérées pour des conditions de gravure identiques.

16. Procédé selon l'une des revendications 12 à 15, dans lequel la formation (105) de la piste conductrice (20) comprend les sous-étapes de : déposer une couche diélectrique (90) recouvrant l'espaceur conducteur (30) ; graver une partie de la couche diélectrique (90) avec arrêt sur le sommet de l'espaceur conducteur (30) de sorte que la couche diélectrique (90) présente un flanc (91) s'étendant perpendiculairement au plan des couches ({X ; Y}) et disposé dans le prolongement d'une partie d'un flanc (30a) de l'espaceur conducteur (30) ; déposer la piste conductrice (20) en partie contre la couche diélectrique (90) et en partie contre l'espaceur conducteur (30), la piste conductrice (20) présentant deux portions consécutives (21, 22), l'une des portions (21), dite « portion parallèle », s'étendant parallèlement au plan des couches ({X ; Y}) et directement contre l'espaceur conducteur (30), et l'autre des portions (22), dite « portion perpendiculaire », s'étendant perpendiculairement au plan des couches ({X ; Y}) et directement contre le flanc (91) de la couche diélectrique (90).

17. Procédé selon l'une des revendications 12 à 15, selon lequel la formation (105) de la piste conductrice (20) comprend les sous-étapes de : déposer une couche isolante (60) contre un flanc (30a) de l'espaceur conducteur (30) ; former une couche diélectrique (90) s'étendant contre la couche isolante (60) tout en laissant une portion de l'espaceur conducteur (30) dégagée ; former un premier terminal conducteur (42) et un deuxième terminal conducteur (43) sur la couche diélectrique, de part et d'autre de l'espaceur, les premier et deuxième terminaux étant distants l'un de l'autre et séparés de l'espaceur par la couche isolante ; déposer la piste conductrice (20) de sorte qu'elle s'étende parallèlement au plan des couches et contre la portion dégagée de l'espaceur, en reliant électriquement les premier et deuxième terminaux.

18. Procédé de fabrication d'un dispositif magnétique (1) comprenant les étapes suivantes : déposer (102) une couche conductrice (70) s'étendant parallèlement à un plan ({X ; Y}), dit « plan des couches », la couche conductrice (70) présentant un couplage spin-orbite moyen strictement inférieur à 136 eV, une longueur moyenne de diffusion de moments orbitaux strictement supérieure à 10 nm et apte à générer un courant de moments orbitaux à partir d'un courant de charges ; déposer (101) un empilement magnétique (10') sur couche conductrice (70), l'empilement magnétique (10') étant destiné à former, après gravure (104), une jonction tunnel magnétique (10) ; graver (104) l'empilement magnétique (10') pour former une jonction tunnel magnétique (10), la gravure étant réalisée à travers un masque de gravure, graver partiellement (103) la couche conductrice (70) à travers le masque de gravure pour former un espaceur conducteur (30) et conserver une partie de la couche conductrice (70) formant une piste conductrice (20) en contact direct avec l'espaceur conducteur (30), l'épaisseur (h30) de l'espaceur conducteur (30) étant inférieure à la longueur moyenne de diffusion de moments orbitaux, la piste conductrice (20) comprenant au moins une portion s'étendant parallèlement au plan des couches ({X ; Y}) et directement contre l'espaceur conducteur (30).
